# EUROPEAN PATENT APPLICATION

(11) **EP 4 730 396 A1**
(43) Date of publication of application: **22.04.2026**
(21) Application number: 24206836.9
(22) Date of filing: 16.10.2024
(51) Int. Cl.: H01L 21/683

(54) **AN ELECTROSTATIC WAFER CLAMP AND A METHOD OF UNLOADING A WAFER THEREFROM**

(71) Applicant: ASML Netherlands B.V., 5500 AH Veldhoven (NL)
(72) Inventor: JANSEN, Maarten, Mathijs, Marinus, 5500 AH Veldhoven (NL); LI, Jun, 5500 AH Veldhoven (NL); REIJNEN, Martinus, Cornelis, 5500 AH Veldhoven (NL); VAN DE VEN, Tijn, Henricus, Maria, 5500 AH Veldhoven (NL); VAN EMPEL, Tjarko, Adriaan, Rudolf, 5500 AH Veldhoven (NL); DRIESSEN, Alexander, Barbara, Jacobus, Maria, 5500 AH Veldhoven (NL); NIKIPELOV, Andrey, 5500 AH Veldhoven (NL)
(74) Representative: ASML Netherlands B.V.

(57) **Abstract**

The invention provides a method of unloading a wafer from an electrostatic wafer clamp having one or more electrodes for clamping the wafer on the wafer clamp, the method comprising: decreasing a clamp voltage of the one or more electrodes of the wafer clamp according to a ramp down pattern from a first, higher voltage to a second, lower voltage; and lifting the wafer from the wafer clamp using a wafer lift arrangement; wherein, prior to the wafer being lifted from the wafer clamp by a first height: the ramp down pattern includes a voltage modulation part prior to reaching the second, lower voltage, said voltage modulation part comprising at least one voltage spike having an opposite polarization and an amplitude of at least 20% of said first, higher voltage; and/or said second, lower voltage has an amplitude in the range of between 5% and 20% of the first, higher voltage.

## Description

### FIELD

The present invention relates to a method of unloading a wafer from an electrostatic wafer clamp, to an electrostatic wafer clamp system for use in such a method, to a semiconductor wafer processing apparatus comprising such a wafer clamp system, and to a computer program, a computer readable medium and a computer apparatus for carrying out such a method.

### BACKGROUND

Light generated by means of a radiation source can be used by exposure apparatuses for semiconductor manufacturing processes. Examples of such exposure apparatuses are a lithographic apparatus, a metrology, or an inspection apparatus. A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer). An example of an inspection apparatus, which may also be referred to as a metrology apparatus, is a mask inspection apparatus which is used for measuring dimensions or detecting defects in masks or mask blanks or a wafer inspection apparatus to measure overlay, critical dimensions or other parameters of the patterns present on the wafer.

To project a pattern on a substrate or wafer a lithographic apparatus may use electromagnetic radiation. The wavelength of this radiation determines the minimum size of features which can be formed on the substrate or wafer. A lithographic apparatus, which uses extreme ultraviolet (EUV) radiation, having a wavelength within the range 4-20 nm, for example 6.7 nm or 13.5 nm, may be used to form smaller features on a substrate or wafer than a lithographic apparatus which uses, for example, radiation with a wavelength of 193 nm.

In an EUV lithographic apparatus, the wafer is typically clamped electrostatically in near-vacuum on a wafer clamp during measurement and/or exposure of the wafer. To achieve good imaging quality and overlay performance, the electrostatic clamping force needs to be relatively high, meaning the clamp voltage of the electrodes of the electrostatic clamp needs to be high. Particles within the EUV lithographic apparatus, especially within the environment where wafer exposure is performed, may contaminate the wafer frontside, resulting in defects in the exposed pattern, and thus yield-loss.

### SUMMARY

It is an object of the invention to reduce contamination of the wafer frontside. It is a further object to provide a method of unloading a wafer from an electrostatic wafer clamp. According to a first aspect of the invention, there is provided a method of unloading a wafer from an electrostatic wafer clamp having one or more electrodes for clamping the wafer on the wafer clamp, the method comprising successive steps of:
- decreasing a clamp voltage of the one or more electrodes of the wafer clamp according to a rampdown pattern from a first, higher voltage which is used to clamp the wafer during a processing action, to a second, lower voltage at which the wafer may be lifted from the wafer clamp; and
- lifting the wafer from the wafer clamp using a wafer lift arrangement;
wherein, prior to the wafer being lifted from the wafer clamp by a first height:
- the rampdown pattern includes a voltage modulation part prior to reaching the second, lower voltage, said voltage modulation part comprising at least one voltage spike having an opposite polarization and an amplitude of at least 20% of said first, higher voltage; and/or
- said second, lower voltage has an amplitude in the range of between 5% and 20% of the first, higher voltage.

The above mentioned high clamp voltage and the resulting strong electric field leads to electric charging of the wafer clamp and the wafer surface, and also of the particles on top of these surfaces. The inventors have found that, in particular during wafer unload, charged particles in strong transient electric fields can get released and reach the wafer frontside, which impacts particles per wafer pass (PWP) and thus to yield-loss at the customer. To be more specific, wafer backside damage, e.g. wafer particles and wafer backside contamination, e.g. contamination from outside scanner sources or contamination from wafer handling have an additional transport mechanism to reach the wafer frontside, or, top surface of the wafer, at wafer unload. Said particles residing on wafer backside and the wafer clamp may get released with high speeds, which, via one or more bounces, may potentially land on the wafer frontside.

By using the method according to the first aspect of the invention, an opposite voltage spike or multiple voltage spikes may be included in the rampdown pattern to destabilize the charged particles residing on charged surfaces or close to other charged particles in order to promote particle release at a defined moment, for example when the wafer remains close to the clamp and the geometric shielding of the small gap is effective to suppress released particle transport to the wafer frontside even after multiple bounces. Also according to the first aspect of the invention a second voltage having an amplitude in the range of between 5% and 20% of the first voltage may be applied to the wafer clamp to achieve at least one of: destabilization of particles during early stages of wafer lift-off (if opposite polarity to the clamping voltage is applied), promoting scattering of the released charged particles that are subject to an additional electric field between the wafer clamp and the wafer (independent of polarity). By using the method according to the first aspect of the invention, the chance of released particles landing on the wafer frontside is reduced, thereby reducing defects and improving yield. Advantageously, combining voltage spike/spikes and second voltage may result in a further improvement in reducing particles landing on the wafer front side and improving yield. Thus, in accordance with the present invention, contamination of the wafer top surface, resulting from unloading the wafer from the electrostatic wafer clamp, is effectively reduced.

Said voltage modulation part and/or said second, lower voltage may be applied prior to the wafer lift arrangement lifting the wafer from the clamp, preferably prior to the wafer lift arrangement starting to move.

The method may be configured such that said voltage modulation part is applied prior to the wafer lift arrangement lifting the wafer from the clamp, preferably prior to the wafer lift arrangement starting to move; and said second, lower voltage is applied until after the wafer has been lifted from the wafer clamp by said first height.

The first height may be 1000µm, preferably 500µm, further preferably 100µm.

The at least one voltage spike may have an amplitude of between 20% and 100%, preferably between 40% and 75% of said first, higher voltage.

The method may be configured such that the rampdown pattern includes said voltage modulation part prior to reaching the second, lower voltage; AND said second, lower voltage is at least substantially zero.

The voltage modulation part may comprise at least two voltage spikes: a first, earlier voltage spike having an opposite polarization and an amplitude of at least 20%, preferably between 20% and 100%, further preferably between 40% and 75%, of said first, higher voltage, and each following voltage spike having an opposite polarization as compared to the preceding voltage spike and having a lower or same amplitude than the preceding voltage spike.

The method may be configured such that the rampdown pattern includes a linear, an exponential or another monotonous function voltage decay from said first, higher voltage to the second, lower voltage; and said second, lower voltage has an amplitude in the range of between 5% and 20% of the first, higher voltage.

The method may further comprise, during lifting of the wafer, increasing the clamp voltage of the one or more electrodes of the wafer clamp from the second, lower voltage, as a function of wafer height, preferably until a second height is reached. The second height is higher than the first height, and may be 1000µm, 3000µm or 10000µm, for example. After the second height is reached, the clamp voltage may be reduced to at least substantially zero.

The lift arrangement may comprise a plurality of wafer lift pins, for example three wafer lift pins, and the lifting the wafer may be by elevating the plurality of wafer lift pins.

The processing action may comprise a lithographic exposure, a wafer inspection, a wafer metrology, a wafer etching, a wafer deposition, or a wafer coating.

According to a second aspect of the invention, there is provided a wafer clamp system, comprising:
- an electrostatic wafer clamp having one or more electrodes for clamping a wafer on the wafer clamp,
- a wafer lift arrangement, and
- a control system configured to:
   - decrease a clamp voltage of the one or more electrodes of the wafer clamp according to a rampdown pattern from a first, higher voltage which is used to clamp the wafer during a processing action, to a second, lower voltage at which the wafer may be lifted from the wafer clamp, and
   - lift the wafer from the wafer clamp using a wafer lift arrangement;
   wherein, prior to the wafer being lifted from the wafer clamp by a first height:
   - the rampdown pattern includes a voltage modulation part prior to reaching the second, lower voltage, said voltage modulation part comprising at least one voltage spike having an opposite polarization and an amplitude of at least 20% of said first, higher voltage; and/or
   - said second, lower voltage has an amplitude in the range of between 5% and 20% of the first, higher voltage.

The control system may be configured to execute the method according to the first aspect of the invention.

The wafer lift arrangement may comprise a plurality of wafer lift pins, wherein the control system is configured to elevate the plurality of wafer lift pins for lifting the wafer from the wafer clamp.

The wafer clamp system may further comprise a voltage source or a power source configured to supply the clamp voltage of the one or more electrodes of the wafer clamp, wherein the control system is configured to control said voltage source or power source to supply the clamp voltage according to the rampdown pattern.

According to a third aspect of the invention, there is provided a semiconductor wafer processing apparatus comprising a wafer clamp system according to the second aspect of the invention.

The apparatus of the third aspect may be a lithographic apparatus, an inspection apparatus, a metrology apparatus, a deposition apparatus, an etching apparatus, or a coating apparatus.

According to a fourth aspect of the invention, there is provided a computer program comprising computer readable instructions configured to cause a processor to carry out a method according to the first aspect of the invention.

According to a fifth aspect of the invention, there is provided a computer readable medium carrying a computer program according to the fourth aspect of the invention.

According to a sixth aspect of the invention, there is provided a computer apparatus comprising:
- a memory storing processor readable instructions; and
- a processor arranged to read and execute instructions stored in said memory,
wherein said processor readable instructions comprise instructions arranged to control the computer to carry out a method according to the first aspect of the invention.

The computer apparatus may form part of the above mentioned control system.

### BRIEF DESCRIPTION OF THE DRAWINGS

Embodiments of the invention will now be described, by way of example only, with reference to the accompanying schematic drawings, in which:
- Figure 1 shows a lithographic system comprising a radiation source SO and a lithographic apparatus LA. The radiation source SO is an EUV source and the lithographic apparatus LA is an EUV scanner;
- Figure 2(a) shows a schematic top view of an electrostatic clamp;
- Figure 2(b) shows a schematic cross-section A-A of Figure 2(a) during clamping of a wafer;
- Figure 2(c) shows a schematic cross-section A-A of Figure 2(a) during lifting of a wafer;
- Figure 3 shows a method of unloading a wafer from an electrostatic wafer clamp of Figure 2;
- Figure 4-10 each shows a method of unloading a wafer from an electrostatic wafer clamp of Figure 2 according to one or more of the embodiments of the present invention;
- Figure 11 shows two examples of the clamp voltage versus lifting height.

### DETAILED DESCRIPTION

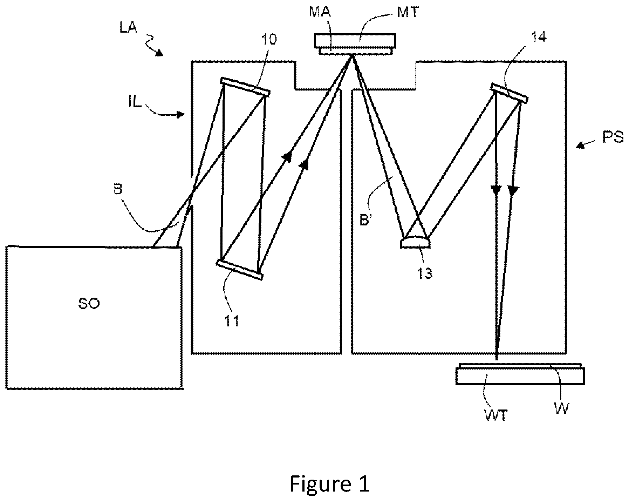

Figure 1 shows a lithographic system comprising a radiation source SO and a lithographic apparatus LA. The radiation source SO is configured to generate an EUV radiation beam B and to supply the EUV radiation beam B to the lithographic apparatus LA. The lithographic apparatus LA comprises an illumination system IL, a support structure MT configured to support a patterning device MA (e.g., a mask), a projection system PS and a substrate table WT configured to support a substrate or a wafer W.

The illumination system IL is configured to condition the EUV radiation beam B before the EUV radiation beam B is incident upon the patterning device MA. Thereto, the illumination system IL may include a facetted field mirror device 10 and a facetted pupil mirror device 11. The faceted field mirror device 10 and faceted pupil mirror device 11 together provide the EUV radiation beam B with a desired cross-sectional shape and a desired intensity distribution. The illumination system IL may include other mirrors or devices in addition to, or instead of, the faceted field mirror device 10 and faceted pupil mirror device 11.

After being thus conditioned, the EUV radiation beam B interacts with the patterning device MA. As a result of this interaction, a patterned EUV radiation beam B' is generated. The projection system PS is configured to project the patterned EUV radiation beam B' onto the substrate or wafer W. For that purpose, the projection system PS may comprise a plurality of mirrors 13,14 which are configured to project the patterned EUV radiation beam B' onto the substrate or wafer W held by the substrate table WT. The projection system PS may apply a reduction factor to the patterned EUV radiation beam B', thus forming an image with features that are smaller than corresponding features on the patterning device MA. For example, a reduction factor of 4 or 8 may be applied. Although the projection system PS is illustrated as having only two mirrors 13,14 in Figure 1, the projection system PS may include a different number of mirrors (e.g. six or eight mirrors).

The substrate or wafer W may include previously formed patterns. Where this is the case, the lithographic apparatus LA aligns the image, formed by the patterned EUV radiation beam B', with a pattern previously formed on the substrate or wafer W.

A relative vacuum, i.e. a small amount of gas (e.g. hydrogen) at a pressure well below atmospheric pressure, may be provided in the radiation source SO, in the illumination system IL, and/or in the projection system PS.

The radiation source SO may be a laser produced plasma (LPP) source, a discharge produced plasma (DPP) source, a free electron laser (FEL) or any other radiation source that is capable of generating EUV radiation.

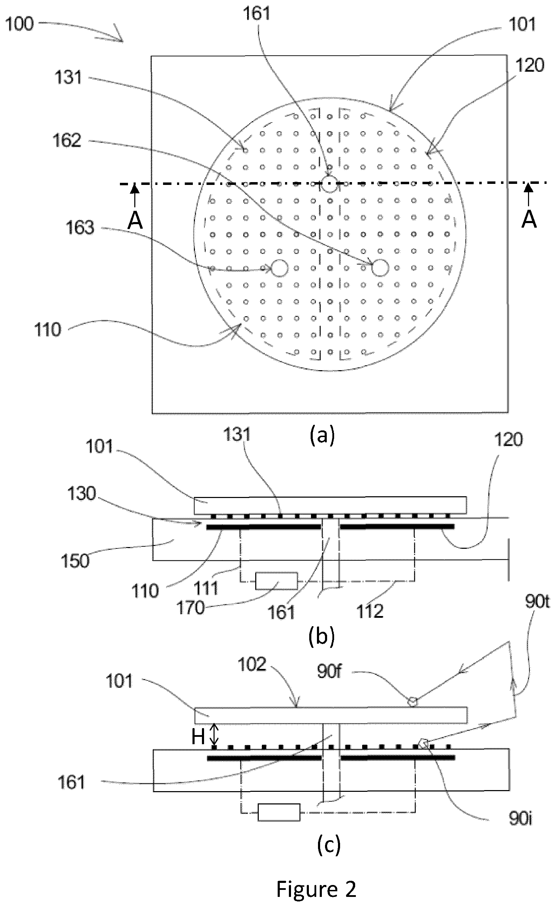

Figure 2(a) shows a schematic top view of an electrostatic clamp. Figure 2(b) and 2(c) show cross-sections A-A of Figure 2(a) respectively during clamping and during lifting of a wafer (101). The wafer clamp is configured to have burls (131) and, at least in the present example, buried, or embedded, electrodes (110, 120) powered via wires (111, 112) and power supply (170). Burls are conducting (at least on their top surfaces) and connected and grounded. The buried electrodes (110, 120) may be independently controlled. In use, during clamping of the wafer (101), a positive voltage may be applied to the first electrode and a negative voltage of comparable magnitude may be applied to the second electrode, or vice versa. The electrodes may each be generally semi-circular, as shown in Figure 2(a).

During unloading, the wafer (101) is lifted from the wafer clamp (100) by a wafer lift arrangement which, in this embodiment, comprises a plurality of wafer lift pins (161, 162, 163). Particles released during wafer unload, may land on the wafer frontside (90i => 90f) via multiple bounces (90t) such as against housing parts (not shown).

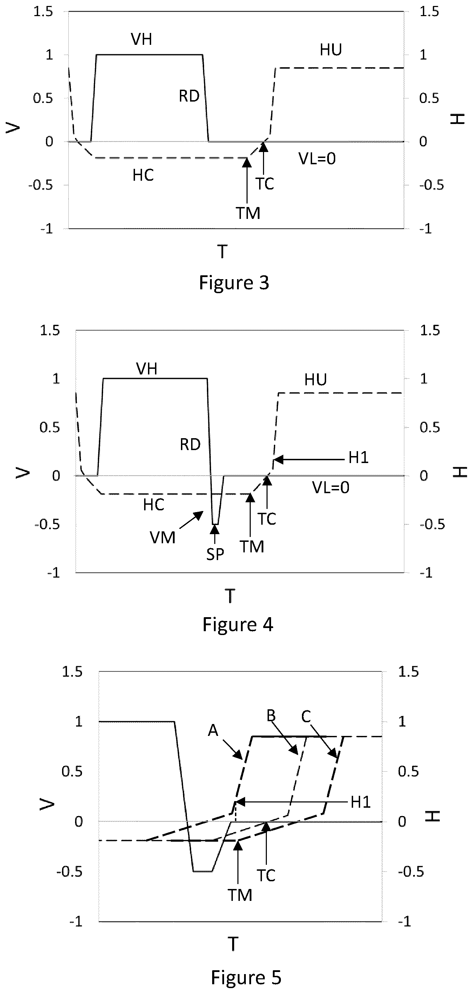

Figure 3 depicts a method of unloading a wafer from an electrostatic wafer clamp of Figure 2. The solid line describes the clamp voltage (V) of one or more electrodes of the wafer clamp. In case of a wafer clamp having multiple electrodes, an opposite clamp voltage may be applied to another electrode as mentioned above. For the purpose of unloading the wafer from the clamp, first the clamp voltage is switched off. That means, said clamp voltage decreases from a first, higher voltage VH to a second, lower voltage VL according to a rampdown pattern RD, which in this case is a linear decay. Note that without loss of generality, the time and clamp voltage are normalized, and the arbitrary values are indications for explanation. A typical value of VH may be in the range of 1 to 5 kV, such as about 3 kV, and VL is substantially 0 V by for example switching off the power supply. The dashed line describes the lifting height (H) of the wafer lift pins. The lifting height H is also illustrated in Figure 2(c). Usually when the wafer is being clamped by the wafer clamp, the top ends of the wafer lift pins are in an inactive position in which they are below the top surface of the wafer clamp as shown in Figure 2(b), that means, at a distance below the wafer backside. For the purpose of the present description, the top surface of the wafer clamp is considered to be at a height H = 0. This lifting height during clamping is illustrated as HC in Figure 3. When a wafer unloading process is initiated, the wafer lift pins start moving upwards at timing TM to first make contact with the wafer at the timing TC, the movement may be configured at a first, lower speed. After that, the wafer lift pins further elevate to lift the wafer from the wafer clamp until a height HU sufficient for the wafer to be unloaded, for example by a wafer gripper of a wafer handler. Shortly after making contact with the wafer, the speed of the elevation may increase to a second, higher speed. The wafer is preferably lifted from the wafer clamp after the rampdown pattern is applied, such that the wafer can be easily lifted by the wafer lift pins.

Figure 4 depicts a method according to a first embodiment of the invention of unloading a wafer from an electrostatic wafer clamp of Figure 2. The rampdown pattern (RD) includes a voltage modulation part (VM) prior to reaching the second, lower voltage (VL), said voltage modulation part comprising at least one voltage spike (SP) having an opposite polarization and an amplitude of about 50% of said first, higher voltage (VH). The second, lower voltage (VL) is 0V as shown in Figure 4, by for example switching off the power supply. The second, lower voltage (VL) may be at least substantially zero, for example within the range of -2% to 2% of VH. Shortly after the wafer lift arrangement making contact with the wafer at timing TC, the speed of its elevation increases to V2. The wafer is lifted after the rampdown pattern is applied. More in general, the clamp voltage rampdown with modulation is executed in full, and the voltage reaches VL prior to the wafer being lifted from the wafer clamp by a first height H1. A preferred value of H1 may be in the range of 100-1000 µm, for example 1000µm, or 500µm or 100µm. A typical range of the amplitude of the voltage spike may be at least 20% of the first, higher voltage (VH). The range may preferably be between 20% and 100%, or further preferably between 40% and 75% of the first, higher voltage (VH). VL may be optimized for an optimal effect of particle reduction under specific conditions, e.g., particle properties, wafer clamp design, wafer defect requirements, etc.

By including the voltage spike with opposite polarization, the charged particles are intentionally released during the voltage polarization switch. It is preferred that the charged particles are released when the wafer is still on the wafer clamp or close to the wafer clamp, because then the geometric shielding is strong, and the released particles cannot easily bounce sideways out of the space between the wafer clamp and the wafer and end up on the wafer frontside. Therefore the rampdown pattern may be configured to reach the second, lower voltage VL prior to the wafer being lifted from the wafer clamp by a first height H1, such as curve A in Figure 5. The rampdown pattern may be configured to reach the second, lower voltage VL prior to the wafer lift arrangement lifting the wafer from the clamp at time TC, such as curve B in Figure 5. Preferably the rampdown pattern may be configured to reach the second, lower voltage VL prior to the wafer lift arrangement starting to move at time TM, such as curve C in Figure 5. Note that Figure 5 is zoomed in in time scale to have a closer view of the wafer clamping and lifting moments.

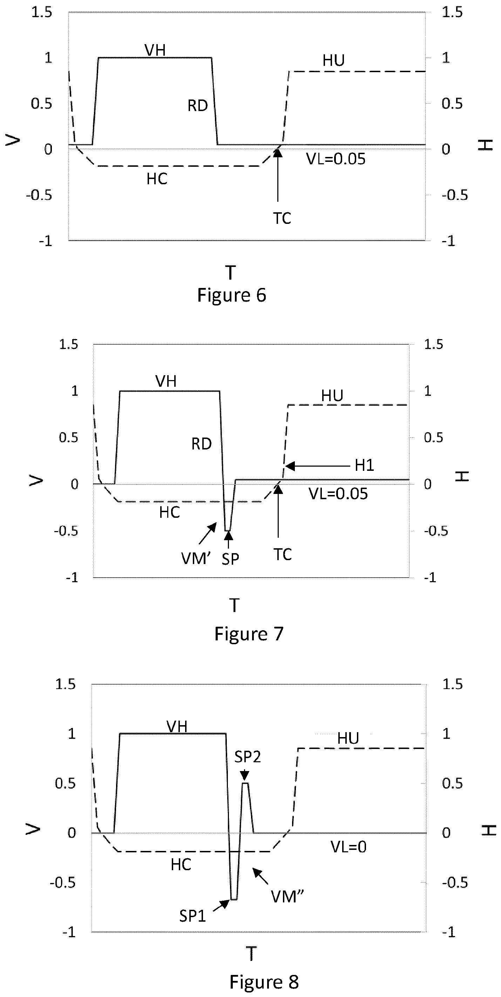

Figure 6 depicts a method of unloading a wafer from an electrostatic wafer clamp of Figure 2 according to a second embodiment of the invention. Compared to the method shown in Figure 3, the second, lower voltage VL is configured to have an amplitude in the range of between 5% and 20% of the first, higher voltage VH, for example between 5% and 15%, or between 5% and 10%. VL may be of the same or the opposite polarization of VH. For example, VL may be +250V or -250V in case that VH would be at a voltage in the range of +1250 to +5000V, such as about +3kV. VL may be +250V or -250V in another case that VH would be at a voltage in the range of -5000V to -1250V, such as about - 3kV. In the example graph shown in figure 6, VL is 5% of VH and has the same polarization as VH. In this embodiment, the rampdown pattern may comprise a linear voltage decay from VH to VL as a function of time. The voltage decay may also follow an exponential function of time, for example. By keeping the VL at said amplitude, at least some of the charged particles are attracted to the wafer clamp by VL during wafer lift, such that less particles get released and transferred to the wafer frontside. Furthermore, the released charged particles scatter more effectively in presence of electric field between clamp and wafer during wafer lift, which leads to a suppressed transport of said particles to the wafer frontside.

Figure 7 depicts a method of unloading a wafer from an electrostatic wafer clamp of Figure 2 according to a third embodiment of the invention, wherein the rampdown pattern includes a voltage modulation part (VM') prior to reaching the second, lower voltage (VL). Said voltage modulation part comprises one voltage spike (SP) having an opposite polarization and an amplitude of at least 20% of said first, higher voltage (VH), and said second, lower voltage (VL) has an amplitude in the range of between 5% and 20% of the first, higher voltage (VH). By including both a voltage spike (SP) and using a non-zero second, lower voltage (VL) in the rampdown pattern, the charged particles are first intentionally released by the voltage spike (SP) before lifting the wafer, and then attracted to the wafer clamp by the non-zero VL during wafer lifting. The effect of the first and the second embodiment may be combined, thus particles transfer to the wafer frontside may be further reduced. The second, lower voltage is preferred to be applied until after the wafer being lifted from the wafer clamp by said first height H1 as shown in Figure 7. The clamp voltage may be configured to be switched off at a later point in time, when the risk of particle transfer to the wafer frontside or particle release in a transient electric field is below a threshold. Alternatively, the clamp voltage can be configured to be switched off at a defined wafer height, which exceeds height H1, in order to avoid risk of electric discharge between various clamp electrodes.

Figure 8 depicts a method of unloading a wafer from an electrostatic wafer clamp of Figure 2 according to another embodiment of the invention, having a voltage modulation part VM" comprising two voltage spikes (SP1, SP2) which are included in the rampdown pattern. The first, earlier voltage spike (SP1) has an opposite polarization of VH, and an amplitude of at least 20% of VH, in this example about 65% of VH. The second later voltage spike (SP2) has an opposite polarization and a lower amplitude than the first voltage spike (SP1), in this example 50% of VH. Note that the amplitudes of the voltage spikes in this embodiment are chosen as an example without loss of generality. The unstable particles formed during the 'harsh' polarization switch of SP1, are removed with the subsequent 'soft' polarity switch of SP2, and particle transfer is further reduced compared to the first embodiment. Optionally, the rampdown pattern may comprise more than two voltage spikes, each later voltage spike having an opposite polarization and a lower or same amplitude than the preceding voltage spike. Unstable particles formed during the preceding voltage spike may be removed with the subsequent polarity switch of the later voltage spike, for a further reduction of particle transfer to the wafer frontside.

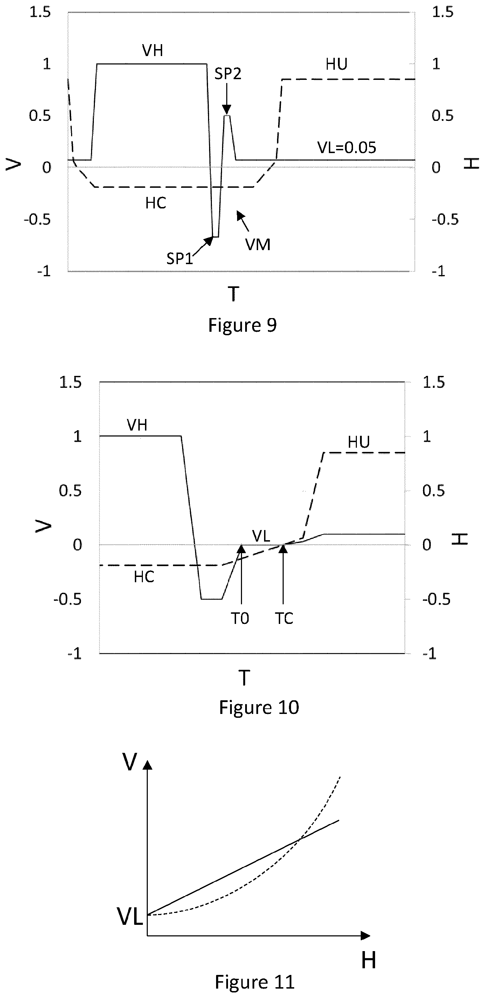

Figure 9 depicts a method of unloading a wafer from a electrostatic wafer clamp of Figure 2 according to yet another embodiment of the invention, wherein two voltage spikes (SP1, SP2) are included in the rampdown pattern similar to the embodiment of Figure 8, and wherein, contrary to the embodiment of Figure 8, the second, lower voltage VL is configured to have an amplitude in the range of between 5% and 20% of the first, higher voltage VH. The effect of one or more voltage spikes and a non-zero VL may be combined, such that the particle transfer to the wafer frontside may be further reduced. Note that more than two voltage spikes may be included in the rampdown pattern, as explained in the previous embodiment.

In the previous embodiments, a substantially constant clamp voltage (VL) is applied during wafer lift, wherein VL may be at least substantially zero or may have an amplitude in the range of between 5% and 20% of the first, higher voltage VH. Alternatively, this voltage may increase as a function of wafer height as shown in yet another embodiment shown in Figure 10. When the wafer is closer to the wafer clamp, a lower clamp voltage is preferred because a high clamp voltage generates a high attracting force between the wafer clamp and the wafer, which may cause a more difficult or relatively violent release of the wafer resulting in more particles. A lower clamp voltage, when the wafer is closer to the wafer clamp, makes it easier for the wafer lift pins to lift the wafer from the wafer clamp. When the wafer is close to the wafer clamp, the slit height between wafer and wafer clamp is small making it more difficult for particles to escape from this slit, thus less particles may end up on the wafer frontside after release. When the wafer is further from the wafer clamp, a higher voltage may be chosen to increase the force to attract the charged particles to the wafer clamp to prevent release and/or to promote scattering of charged particles that do release to reduce transport to the wafer frontside. With the larger gap between wafer and clamp, and correspondingly larger voltage, the electric field in the gap can be maintained at a level that allows the wafer lift pins to lift the wafer. As shown in Figure 10, after the rampdown pattern, the clamp voltage first reaches VL at T0, and the wafer lift pins elevate to make contact with the wafer at TC. During wafer lift from TC, the amplitude of the clamp voltage may increase as a function of the lifting height (H). This increase may be linear, exponential or any other increase function. Two examples of the increase function are shown in Figure 11. After a height (H2) is reached, not shown in figures, the voltage can be reduced to at least substantially zero.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments of the invention in the context of a lithographic apparatus, embodiments of the invention may be used in other apparatus. Embodiments of the invention may form part of a mask inspection apparatus, a metrology apparatus, any apparatus that measures or processes an object such as a wafer (or other substrate) or mask (or other patterning device), a deposition apparatus, a coating apparatus, or an etching apparatus. These apparatus may be generally referred to as lithographic tools. Such a lithographic tool may use vacuum conditions or ambient (non-vacuum) conditions.

Although specific reference may have been made above to the use of embodiments of the invention in the context of optical lithography, it will be appreciated that the invention, where the context allows, is not limited to optical lithography and may be used in other applications, for example imprint lithography.

Where the context allows, embodiments of the invention may be implemented in hardware, firmware, software, or any combination thereof. Embodiments of the invention may also be implemented as instructions stored on a machine-readable medium, which may be read and executed by one or more processors. A machine-readable medium may include any mechanism for storing or transmitting information in a form readable by a machine (e.g., a computing device). For example, a machine-readable medium may include read only memory (ROM); random access memory (RAM); magnetic storage media; optical storage media; flash memory devices; electrical, optical, acoustical or other forms of propagated signals (e.g. carrier waves, infrared signals, digital signals, etc.), and others. Further, firmware, software, routines, instructions may be described herein as performing certain actions. However, it should be appreciated that such descriptions are merely for convenience and that such actions in fact result from computing devices, processors, controllers, or other devices executing the firmware, software, routines, instructions, etc. and in doing that may cause actuators or other devices to interact with the physical world.

While specific embodiments of the invention have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

## Claims

1. A method of unloading a wafer from an electrostatic wafer clamp having one or more electrodes for clamping the wafer on the wafer clamp, the method comprising the successive steps of:
- decreasing a clamp voltage of the one or more electrodes of the wafer clamp according to a rampdown pattern from a first, higher voltage which is used to clamp the wafer during a processing action, to a second, lower voltage at which the wafer may be lifted from the wafer clamp; and
- lifting the wafer from the wafer clamp using a wafer lift arrangement;
wherein, prior to the wafer being lifted from the wafer clamp by a first height:
- the rampdown pattern includes a voltage modulation part prior to reaching the second, lower voltage, said voltage modulation part comprising at least one voltage spike having an opposite polarization and an amplitude of at least 20% of said first, higher voltage; and/or
- said second, lower voltage has an amplitude in the range of between 5% and 20% of the first, higher voltage.

2. The method of claim 1, wherein said voltage modulation part and/or said second, lower voltage is/are applied prior to the wafer lift arrangement lifting the wafer from the clamp, preferably prior to the wafer lift arrangement starting to move.

3. The method of claim 1 or 2, wherein said voltage modulation part is applied prior to the wafer lift arrangement lifting the wafer from the clamp, preferably prior to the wafer lift arrangement starting to move;
and said second, lower voltage is applied until after the wafer has been lifted from the wafer clamp by said first height.

4. The method of any preceding claim, wherein the first height is 1000µm, preferably 500µm, further preferably 100µm.

5. The method of any preceding claim, wherein the at least one voltage spike has an amplitude of between 20% and 100%, preferably between 40% and 75% of said first, higher voltage.

6. The method of any preceding claim, wherein
- the rampdown pattern includes said voltage modulation part prior to reaching the second, lower voltage; and
- said second, lower voltage is at least substantially zero.

7. The method of any preceding claim, wherein the voltage modulation part comprises at least two voltage spikes: a first, earlier voltage spike having an opposite polarization and an amplitude of at least 20%, preferably between 20% and 100%, further preferably between 40% and 75%, of said first, higher voltage; and each later voltage spike having an opposite polarization and a lower or same amplitude than the preceding voltage spike.

8. The method of claim 1 or 4, wherein
- the rampdown pattern includes a linear or an exponential voltage decay from said first, higher voltage to the second, lower voltage; and
- said second, lower voltage has an amplitude in the range of between 5% and 20% of the first, higher voltage.

9. The method of any preceding claim, wherein the processing action comprises a lithographic exposure, a wafer inspection, a wafer metrology, a wafer etching, a wafer deposition, or a wafer coating.

10. A wafer clamp system, comprising
- an electrostatic wafer clamp having one or more electrodes for clamping a wafer on the wafer clamp,
- a wafer lift arrangement, and
- a control system configured to:
- decrease a clamp voltage of the one or more electrodes of the wafer clamp according to a rampdown pattern from a first, higher voltage which is used to clamp the wafer during a processing action, to a second, lower voltage at which the wafer may be lifted from the wafer clamp, and
- lift the wafer from the wafer clamp using a wafer lift arrangement;
wherein, prior to the wafer being lifted from the wafer clamp by a first height:
- the rampdown pattern includes a voltage modulation part prior to reaching the second, lower voltage, said voltage modulation part comprising at least one voltage spike having an opposite polarization and an amplitude of at least 20% of said first, higher voltage; and/or
- said second, lower voltage has an amplitude in the range of between 5% and 20% of the first, higher voltage.

11. The wafer clamp system of claim 10, wherein the control system is configured to execute the method according to any one of claims 2-9.

12. The wafer clamp system of claim 10 or 11, wherein the wafer lift arrangement comprises a plurality of wafer lift pins that are controlled by the controller to rise for contacting the wafer and lifting the wafer from the wafer clamp.

13. A semiconductor wafer processing apparatus comprising the wafer clamp system of claim 10, 11 or 12.

14. The apparatus of claim 13 being a lithographic apparatus, an inspection apparatus, a metrology apparatus, a deposition apparatus, an etching apparatus, or a coating apparatus.

15. A computer apparatus comprising:
- a memory storing processor readable instructions; and
- a processor arranged to read and execute instructions stored in said memory,
wherein said processor readable instructions comprise instructions arranged to control the computer to carry out a method according to any one of claims 1 to 9.
